# EUROPEAN PATENT APPLICATION

(11) **EP 2 398 107 A2**
(43) Date of publication of application: **21.12.2011**
(21) Application number: 11170059.7
(22) Date of filing: 15.06.2011
(51) Int. Cl.: H01M 10/48

(54) **Secondary battery device**

(30) Priority: 16.06.2010 JP 2010137673
(71) Applicant: Kabushiki Kaisha Toshiba, Tokyo 105-8001 (JP)
(72) Inventor: Ashida, Kazuhide, Minato-ku Tokyo 105-8001 (JP)
(74) Representative: Fuchs

(57) **Abstract**

According to one embodiment, a device includes an assembled battery (10) including cells (BT), a circuit (20) which measures a potential difference of each cell (BT), a current detector (30) which detects a value of a current in the assembled battery (10), a determination module (52) including a first reference (L1) and a second reference (H1) which determines whether the potential difference is higher than the first reference (L1) and is lower than the second reference (H1), and a module (54) which calculates a charge/discharge capacity, based on a current integration value which is detected by the current detector (30), when the determination module(52) determines that the potential difference is higher than the first reference (L1) and is lower than the second reference (H1), and calculates the charge/discharge capacity, based on a state of charge corresponding to the potential difference, when the determination module (52) determines that the potential difference is not higher than the first reference (L1) or is not lower than the second reference (H1).

## Description

### FIELD

Embodiments described herein relate generally to a secondary battery device.

### BACKGROUND

In a conventional secondary battery device, as a method of calculating a charge/discharge capacity of a secondary battery cell, there are known a method of making an estimation from a potential difference of each secondary battery cell, and a method of integrating a charge/discharge current. The method of making an estimation from the potential differences cannot be adopted when an open-circuit voltage cannot be measured, or when a voltage variation due to a charge/discharge capacity is small. On the other hand, in the method of integrating a charge/discharge current, as integration errors are gradually accumulated, such a case may occur that a difference occurs between an actual charge/discharge capacity and a calculated charge/discharge capacity.

### BRIEF DESCRIPTION OF THE DRAWINGS

FIG. 1 schematically shows a structure example of a secondary battery device according to an embodiment.
FIG. 2 shows an example of charge/discharge characteristics of a secondary battery cell and voltage reference setting.
FIG. 3 is a view for explaining an example of a method of estimating a charge/discharge capacity by integrating a discharge current and a charge current.
FIG. 4 is a view for explaining a method of calculating a charge/discharge capacity from a terminal open-circuit voltage of the secondary battery cell.
FIG. 5 is a flow chart illustrating an example of a charge/discharge capacity calculation method of a secondary battery device according to a first embodiment.
FIG. 6 shows another example of charge/discharge characteristics of a secondary battery cell and voltage reference setting.
FIG. 7 is a flow chart illustrating an example of a charge/discharge capacity calculation method of a secondary battery device according to a second embodiment.

### DETAILED DESCRIPTION

In general, according to one embodiment, a secondary battery device comprises an assembled battery including a plurality of secondary battery cells; a voltage measuring circuit configured to measure a potential difference of each secondary battery cell; a current detection circuit configured to detect a value of a current flowing in the assembled battery; a determination module in which a low-potential-side reference and a high-potential-side reference are set, and which is configured to determine whether the potential differences is higher than the low-potential-side reference and is lower than the high-potential-side reference; and a charge/discharge capacity arithmetic module configured to calculate a charge/discharge capacity of the secondary battery cell, based on a current integration value which is detected by the current detection circuit, when the determination module determines that the potential differences is higher than the low-potential-side reference and is lower than the high-potential-side reference, and to calculate the charge/discharge capacity, based on a state of charge corresponding to the potential difference, when the determination module determines that the potential difference is not higher than the low-potential-side reference or is not lower than the high-potential-side reference.

A secondary battery device according to a first embodiment will now be described with reference to the accompanying drawings.

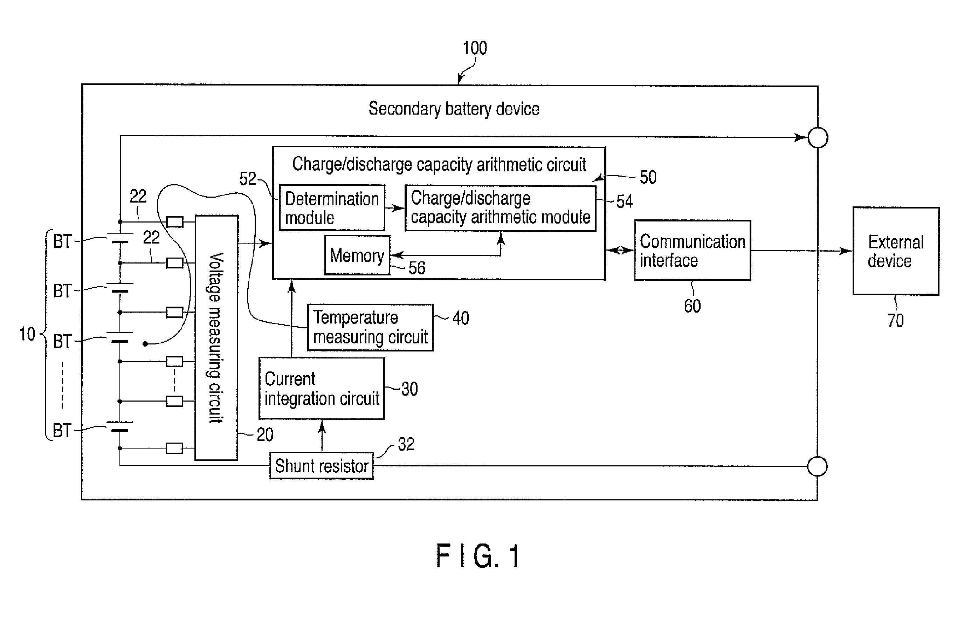

FIG. 1 schematically shows a structure example of a secondary battery device 100 according to the embodiment. The secondary battery device 100 according to the embodiment is a secondary battery device which is used as a driving power source of, for example, a hybrid automobile or an electric power-assisted bicycle.

The secondary battery device 100 comprises an assembled battery 10 including a plurality of secondary battery cells BT which are connected in series; a voltage measuring circuit 20 which measures an potential difference of each secondary battery cell BT; a shunt resistor functioning as a current measuring resistor 32 which is connected in series to the assembled battery 10; a current integration circuit 30 which integrates a value of an electric current flowing in the assembled battery 10; a temperature measuring circuit 40 which measures a temperature by a temperature sensor TS disposed near the secondary battery cells BT; a charge/discharge capacity arithmetic circuit 50 which calculates a charge/discharge capacity of plural secondary battery cells BT; and a communication interface 60 which transmits a measurement value and an arithmetic value.

The voltage measuring circuit 20 measures a voltage of each of the secondary battery cells BT which constitute the assembled battery 10, and transmits voltage values to the charge/discharge capacity arithmetic circuit 50. A plurality of voltage measuring wiring lines 22 are connected between the voltage measuring circuit 20 and the assembled battery 10. One end of the voltage measuring wiring line 22 is connected to a positive terminal or a negative terminal of the secondary battery cell BT, and the other end of the voltage measuring wiring line 22 is connected to the voltage measuring circuit 20. A resistor R is attached in series to the voltage measuring wiring line 22.

The current integration circuit 30 detects a voltage drop of the current measuring resistor 32 which is connected in series to the assembled battery 10, thereby detecting values of a charge current and a discharge current of the assembled battery 10, and integrating the detected charge current and discharge current. An integration value, which is integrated by the current integration circuit 30, is sent to the charge/discharge capacity arithmetic circuit 50. In addition, an instantaneous current value of a current flowing in the assembled battery 10 is also sent to the charge/discharge capacity arithmetic circuit 50.

The temperature measuring circuit 40 detects a temperature of the secondary battery cell BT from the temperature sensor TS which is disposed near the secondary battery cell BT. The temperature measuring circuit 40 sends the detected temperature value of the secondary battery cell BT to the charge/discharge capacity arithmetic circuit 50.

The charge/discharge capacity arithmetic circuit 50 calculates the charge/discharge capacity of the secondary battery cells BT from the potential difference of each secondary battery cell BT, the instantaneous current value and the battery temperature value. The charge/discharge capacity arithmetic circuit 50 comprises a determination module which compares the potential difference with a preset voltage reference; a charge/discharge capacity arithmetic module 54 which calculates a charge/discharge capacity by a method corresponding to a comparison result by the determination module 52; and a memory 56 which records, for example, a data table or an arithmetic formula for calculating a charge/discharge capacity, and a calculated charge/discharge capacity. The charge/discharge capacity arithmetic circuit 50 sends the calculated charge/discharge capacity to the communication interface 60. The communication interface 60 is configured to be able to send the charge/discharge capacity to an external device 70.

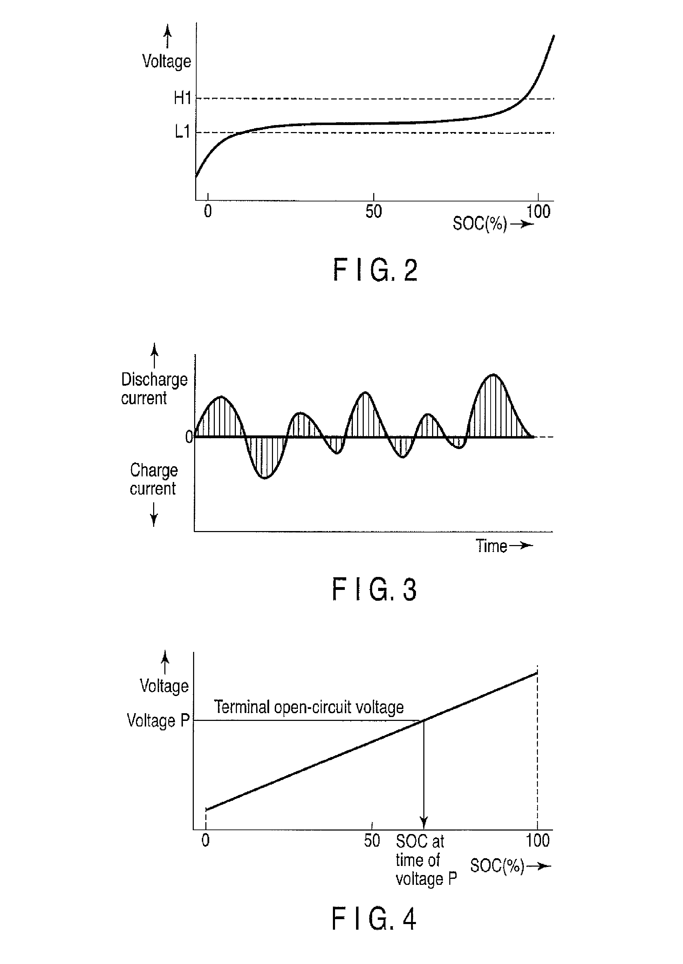

FIG. 2 shows an example of charge/discharge characteristics of the secondary battery cell BT and the voltage references used by the determination module 52. FIG. 2 shows charge/discharge characteristics of the secondary battery cell, with an abscissa indicating a state of charge (SOC) (%), and an ordinate indicating a voltage.

In the determination module 52 of the charge/discharge capacity arithmetic circuit 50, at least two voltage reference values, i.e. a low-potential-side reference L1 (V) and a high-potential-side reference H1 (V), which are indicated in the charge/discharge characteristics of the secondary battery cell BT, are set. The determination module 52 is configured to determine whether the value of the potential difference, which has been received from the voltage measuring circuit 20, is higher than the reference L1 (V) and is lower than the reference H1 (V).

The charge/discharge capacity arithmetic module 54 is configured to calculate the charge/discharge capacity by using the integration value of the charge/discharge current, when the determination module 52 has determined that the value of the potential difference is higher than the reference L1 (V) and is lower than the reference H1 (V). The charge/discharge capacity arithmetic module 54 is configured to calculate the charge/discharge capacity by using the potential difference, when the determination module 52 has determined that the value of the potential difference is not higher than the reference L1 (V) and is not lower than the reference H1 (V).

In the case where the potential difference of the secondary battery cell BT is between the reference L1 (V) and reference H1 (V), the inclination of the charge/discharge characteristics shown in FIG. 2 is small. Specifically, the case, in which the potential difference of the secondary battery cell BT is between the reference L1 (V) and reference H1 (V), corresponds to a region where the variation of the potential difference relative to the state of charge is small.

For example, when it is assumed that the detection resolution of the necessary charge/discharge capacity is A (%) and the voltage resolution of the voltage measuring circuit 20 is R (V), the low-potential-side reference L1 (V) and high-potential-side reference H1 (V) are set by using the potential difference at a point where the variation ratio d (V/%) of the potential difference to the charge/discharge capacity in the charge/discharge characteristics of the secondary battery cell BT satisfies |Ad| ≥ R.

By setting the voltage references L1 and H1 in this manner, the charge/discharge capacity can be calculated by using the potential difference in the region where the voltage measuring circuit 20 can precisely measure the variation of the potential difference, and the charge/discharge capacity can be calculated by using the integration value of the charge/discharge current in the other regions. Therefore, by setting the voltage references L1 and H1 in the above-described manner, the charge/discharge capacity can be calculated more exactly.

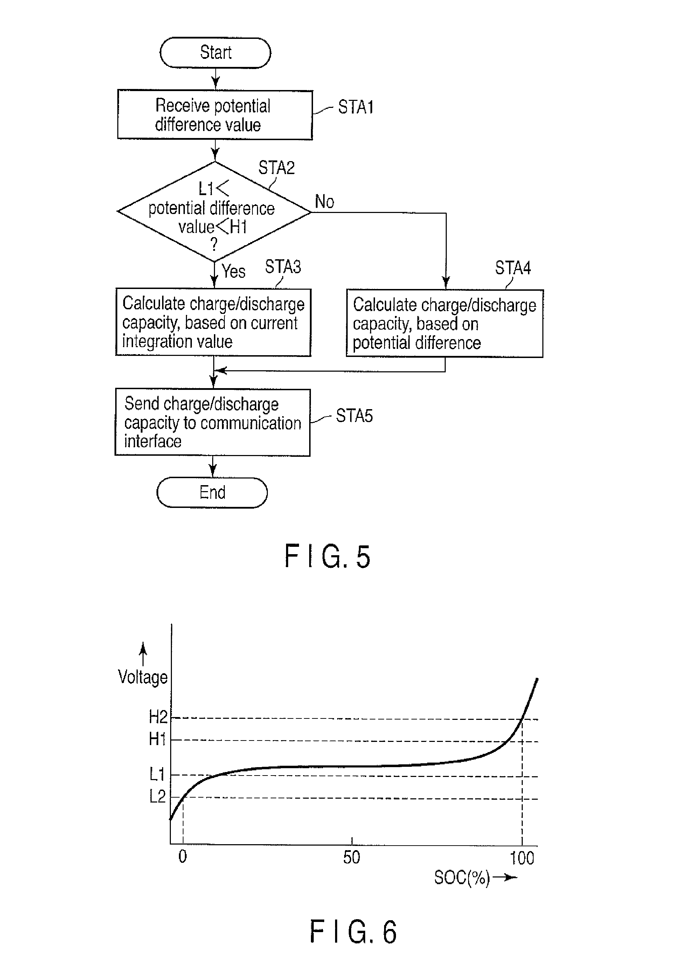

FIG. 5 is a flow chart illustrating an example of the operation of the charge/discharge capacity arithmetic circuit 50 of the above-described secondary battery device 100.

If the charge/discharge capacity arithmetic circuit 50 receives the potential difference of each secondary battery cell BT from the voltage measuring circuit 20 (step STA1), the charge/discharge capacity arithmetic circuit 50 determines whether the value of the potential difference of each secondary battery cell BT is higher than the reference L1 (V) and is lower than the reference H1 (V) (step STA2).

When the potential difference of the secondary battery cell BT is higher than the reference L1 (V) and is lower than the reference H1 (V), the charge/discharge capacity arithmetic circuit 50 calculates the charge/discharge capacity, based on the current integration value which is sent from the current integration circuit 30 (step STA3).

FIG. 3 is a view for explaining a method of estimating a charge capacity and a discharge capacity by integrating a discharge current and a charge current. FIG. 3 shows an example of a time-based variation of a current flowing in the assembled battery 10, with an abscissa indicating time, and an ordinate indicating a discharge current and a charge current.

The charge/discharge capacity arithmetic circuit 50 integrates the discharge capacity, for example, when the assembled battery 10 is discharged, and integrates the charge capacity when the assembled battery 10 is charged, thereby calculating the charge capacity and discharge capacity of the secondary battery cell BT.

When the potential difference of the secondary battery cell BT is not higher than the reference L1 (V) or is not lower than the reference H1 (V), the charge/discharge capacity arithmetic circuit 50 calculates the charge/discharge capacity, based on the potential difference value of the secondary battery cell BT, the instantaneous current value and the temperature value (step STA4).

FIG. 4 is a view for explaining a method of calculating a charge/discharge capacity from a terminal open-circuit voltage of the secondary battery cell BT. FIG. 4 shows an example of the relationship between the potential difference and the state of charge, with an abscissa indicating the state of charge (%), and an ordinate indicating a potential difference of the secondary battery cell BT.

The charge/discharge capacity arithmetic circuit 50 calculates the charge/discharge capacity, by calculating the value of the state of charge corresponding to the received potential difference value of the secondary battery cell BT. The charge/discharge capacity arithmetic circuit 50 may be configured to correct the state of charge, which has been calculated from the potential difference value, on the basis of the instantaneous current value and the temperature value, and to calculate the charge/discharge capacity in which the instantaneous current value and the temperature value are reflected. In addition, the charge/discharge capacity arithmetic circuit 50 may be configured to calculate the charge/discharge capacity, based on a data table which stores values of charge/discharge capacities corresponding to a plurality of potential difference values.

Subsequently, the charge/discharge capacity arithmetic circuit 50 records the calculated value of the charge/discharge capacity in the memory, and sends the calculated value to the communication interface 60 (step STA5).

For example, if the charge/discharge capacity is calculated, based on the relationship between the potential difference value and the state of charge, for example, as shown in FIG. 4, in the range in which the variation of the potential difference of the secondary battery cell BT is small and which meets the relationship, reference L1 < potential difference < reference H1, it would be difficult, in some cases, to exactly calculate the state of charge if an error is included in the potential difference value.

On the other hand, if the charge/discharge capacity is calculated as described above, the charge/discharge capacity of the battery is calculated by integrating the charge/discharge current in the range where the variation of the potential difference of the secondary battery cell BT is small and which meets the relationship, reference L1 < potential difference < reference H1. Thus, even in the case where an error is included in the potential difference value, a more exact charge/discharge capacity can be calculated.

In the case where the potential difference is not higher than the reference L1 (V) or is not lower than the reference H1 (V), a more exact charge/discharge capacity, which does not include an integration error of the current value, etc., can be calculated by executing an arithmetic operation of the charge/discharge capacity on the basis of the potential difference, etc.

In short, according to the secondary battery device of the present embodiment, it is possible to provide a secondary battery device which estimates the charge/discharge capacity of the secondary battery cell with higher accuracy.

Next, a secondary battery device according to a second embodiment is described with reference to the drawings. In the description below, the same structural parts as those of the secondary battery device of the above-described first embodiment are denoted by like reference numerals, and a description thereof is omitted.

In the secondary battery device of this embodiment, a low-potential-side reference L2 (V) and a high-potential-side reference H2 (V) are further set in the determination module 52 of the charge/discharge capacity arithmetic circuit 50. The reference L2 (V) is a value which is lower than the reference L1 (V). The reference H2 (V) is a value which is higher than the reference H1 (V). In the present embodiment, the reference L2 (V) is a potential difference at a time when the state of charge is 0 (%), and the reference H2 (V) is a potential difference at a time when the state of charge is 100 (%).

In the charge/discharge characteristics of the secondary battery cell BT, which are shown in FIG. 2, the variation ratio of the potential difference of the secondary battery cell BT to the charge/discharge capacity is large at regions where the charge/discharge capacity of the secondary battery cell BT is particularly large or small. Thus, at the regions where the charge/discharge capacity of the secondary battery cell BT is particularly large or small, it is possible to exactly calculate the charge/discharge capacity from the potential difference.

In the secondary battery device 100 of this embodiment, two levels, i.e. the low-potential-side reference L2 (V), which is lower than the voltage reference L1, and the high-potential-side reference H2 (V), which is higher than the voltage reference H1, are additionally set. When the potential difference of the secondary battery cell BT is lower than the reference L2 or higher than the reference H2, the current integration value is corrected and the charge/discharge capacity of the secondary battery cell BT is initialized.

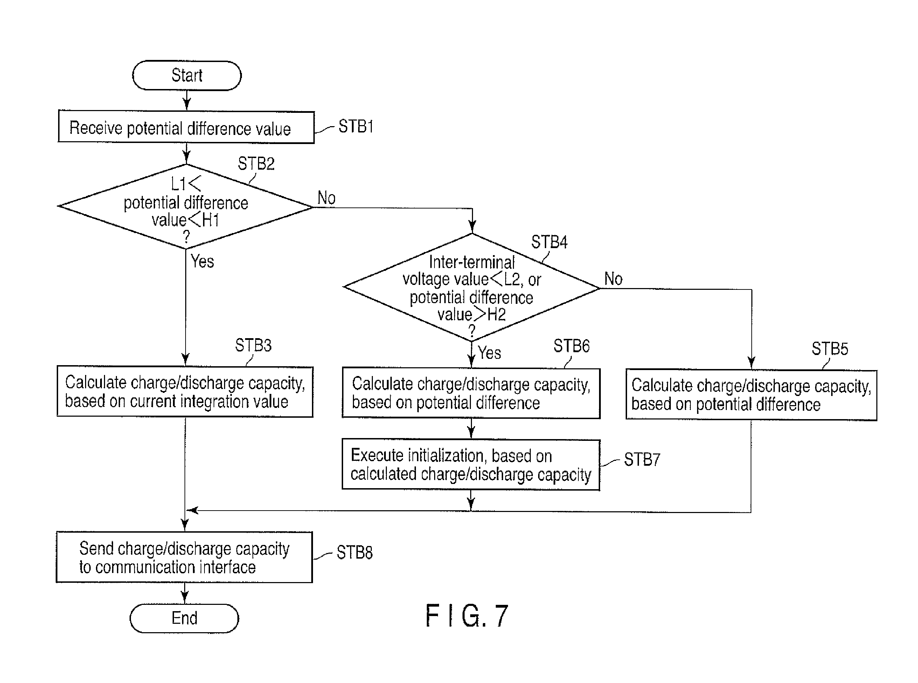

FIG. 7 is a flow chart illustrating an example of a charge/discharge capacity calculation method of a secondary battery device according to this embodiment.

If the charge/discharge capacity arithmetic circuit 50 receives the potential difference (step STB1), the determination module 52 determines whether the value of the potential difference, which has been received from the voltage measuring circuit 20, is higher than the reference L1 (V) and is lower than the reference H1 (V) (step STB2).

When the determination module 52 has determined that the value of the potential difference is higher than the reference L1 (V) and is lower than the reference H1 (V), the charge/discharge capacity arithmetic module 54 calculates the charge/discharge capacity, based on the current integration value (step STB3).

When the determination module 52 has determined that the value of the potential difference is not higher than the reference L1 (V) or is not lower than the reference H1 (V), the determination module 52 further determines whether the value of the potential difference is lower than the reference L2 (V) or is higher than the reference H2 (step STB4).

When the determination module 52 has determined that the potential difference is lower than the reference L2 (V) or is higher than the reference H2, the charge/discharge capacity arithmetic module 54 calculates the charge/discharge capacity, based on the potential difference (step STB6). Subsequently, based on the calculated charge/discharge capacity, the charge/discharge capacity arithmetic module corrects and initializes the current integration value (step STB7).

When the determination module 52 has determined that the potential difference is not lower than the reference L2 (V) or is not higher than the reference H2, the charge/discharge capacity arithmetic module 54 calculates the charge/discharge capacity, based on the potential difference (step STB5). Subsequently, the charge/discharge capacity arithmetic module 54 sends the calculated charge/discharge capacity to the communication interface 60 (step STB8).

As has been described above, with the voltage references L2 and H2 being additionally set, the charge/discharge capacity is initialized when the potential difference is particularly high or low. Thereby, the charge/discharge capacity can be calculated by suppressing the influence of the error due to the integration of the charge/discharge current. Therefore, it is possible to provide the secondary battery device which more exactly estimates the charge/discharge capacity of the secondary battery cell.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A secondary battery device **characterized by** comprising:
an assembled battery (10) including a plurality of secondary battery cells (BT);
a voltage measuring circuit (20) configured to measure a potential difference of each secondary battery cell (BT);
a current detection circuit (30) configured to detect a value of a current flowing in the assembled battery (10);
a determination module (52) in which a low-potential-side voltage reference (L1) and a high-potential-side voltage reference (H1) are set, and which is configured to determine whether the potential difference is higher than the low-potential-side voltage reference (L1) and is lower than the high-potential-side voltage reference (H1); and
a charge/discharge capacity arithmetic module (54) configured to calculate a charge/discharge capacity of the secondary battery cell, based on a current integration value which is detected by the current detection circuit (30), when the determination module (52) determines that the potential difference is higher than the low-potential-side voltage reference (L1) and is lower than the high-potential-side voltage reference (H1), and to calculate the charge/discharge capacity, based on a state of charge corresponding to the potential difference, when the determination module (52) determines that the potential difference is not higher than the low-potential-side voltage reference (L1) or is not lower than the high-potential-side voltage reference (H1).

2. The secondary battery device of claim 1, **characterized in that** a second low-potential-side voltage reference (L2), which is lower than the low-potential-side voltage reference (L1), and a second high-potential-side voltage reference (H2), which is higher than the high-potential-side voltage reference (H1), are additionally set in the determination module (52), and the determination module (52) is configured to determine whether the potential difference is lower than the second low-potential-side voltage reference (L2) or is higher than the second high-potential-side voltage reference (H2), when the potential difference is not higher than the low-potential-side voltage reference (L1) or is not lower than the high-potential-side voltage reference (H1), and
the charge/discharge capacity arithmetic module (54) is configured to initialize the current integration value, based on a state of charge corresponding to the potential difference, when the determination module (52) determines that the potential difference is lower than the second low-potential-side voltage reference (L2) or is higher than the second high-potential-side voltage reference (H2).

3. The secondary battery device of claim 2, **characterized in that** the second low-potential-side voltage reference (L2) is a potential difference at a time when the state of charge is 0 (%), and the second high-potential-side voltage reference (H2) is a potential difference at a time when the state of charge is 100 (%).

4. The secondary battery device of any one of claims 1 to 3, **characterized in that** when it is assumed that a detection resolution of the charge/discharge capacity is A (%) and a voltage resolution of the voltage measuring circuit (20) is R (V), each of the low-potential-side reference L1 and the high-potential-side reference H1 is a potential difference at a time when a variation ratio d (V/%) of the potential difference to the charge/discharge capacity in charge/discharge characteristics of the secondary battery cell (BT) is |Ad| ≥ R.
